(19) Europäisches Patentamt
European Patent Office
Office européen des brevets

(11) **EP 2 693 226 A1**

(12) **EUROPEAN PATENT APPLICATION**
published in accordance with Art. 153(4) EPC

(43) Date of publication:
**05.02.2014 Bulletin 2014/06**

(51) Int Cl.:
***G01R 27/26*** *(2006.01)* ***H02P 21/14*** *(2006.01)*

(21) Application number: **11842460.5**

(22) Date of filing: **30.03.2011**

(86) International application number:
**PCT/CN2011/072314**

(87) International publication number:
**WO 2012/129797 (04.10.2012 Gazette 2012/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(71) Applicant: **Shenzhen Invt Electric Co., Ltd.**
**Shenzhen, Guangdong 518057 (CN)**

(72) Inventors:
• **WANG, Yulei**
  **Shenzhen City, Guangdong 518057 (CN)**

• **XU, Tiezhu**
  **Shenzhen City, Guangdong 518057 (CN)**

(74) Representative: **Zinnecker, Armin et al**
**Lorenz Seidler Gossel**
**Rechtsanwälte - Patentanwälte**
**Widenmayerstrasse 23**
**80538 München (DE)**

(54) **INDUCTANCE PARAMETER IDENTIFICATION METHOD OF SYNCHRONOUS MOTOR AND IMPLEMENTATION SYSTEM THEREOF**

(57)  The present invention discloses an inductance parameter identification method for a synchronous motor and an implementation system thereof. The method comprises: injecting a balanced three-phase high-frequency voltage or current signal to the synchronous motor; obtaining amplitudes of a positive sequence component and a negative sequence component that have the same frequency as the injected voltage or current of a feedback high-frequency current or voltage; and calculating d-axis inductance $L_d$ and q-axis inductance Lq of the synchronous motor. The present invention can achieve accurate identification of the d-axis inductance and q-axis inductance of a synchronous motor using a general-purpose frequency-variable device without hardware cost increase. The present invention is easy to implement. It imposes no high requirements on the accuracy of the sampling of the feedback current from the motor. The frequency and amplitude of the high-frequency voltage signal injected to the motor are easy to control. Moreover, the d-axis inductance and q-axis inductance of the motor can be directly identified, whether the shaft of the motor is free or braked, without affecting the accuracy of identification.

**FIG. 1**

**Description**

**FIELD OF THE INVENTION**

The present invention relates to an inductance parameter identification method and an implementation system thereof, and in particular to an inductance parameter identification method for a synchronous motor and an implementation system thereof.

**BACKGROUND OF THE INVENTION**

Due to their advantages including high power density, low losses, high efficiency, high power factor and suitability for direct drive, permanent magnet synchronous motors are increasingly widely applied in the field of electric transmission. In early stages, the synchronous motor generally adopted vector control with encoder feedback, or open-loop voltage/ frequency (V/F) control, which remarkably restricted its applications. Currently, speed sensorless vector control techniques for synchronous motors have been developed by a small number of inverter companies and employed in the fields such as plastic, machinery, oil wells, fans and water pumps. Generally, speed sensorless vector control is rotor flux linkage (i.e., permanent magnet flux linkage) oriented, and knowledge of the inductance parameter of the motor is needed to identify the rotor flux linkage of the motor, which comprises direct-axis (d-axis) inductance $L_d$ and quadrature-axis (q-axis) inductance Lq. Currently, the direct-axis inductance $L_d$ and quadrature-axis inductance Lq of a synchronous motor are identified using an impulse voltage application method. The method comprises the following steps.

1. An arbitrary axis is defined as the d-axis (i.e., magnetic pole axis), and a d-axis voltage is then applied so that the magnetic field of the rotor is aligned to the d-axis.

2. A fixed d-axis voltage impulse is applied to the motor, the feedback current at the d-axis is sampled, and the d-axis inductance is calculated according to the equation:

$$i_d = \frac{u_d}{r_s}(1 - e^{-\frac{r_s}{L_d}t})$$

.

3. Fixed q-axis voltage impulses are applied to the motor for a short period of time, and the feedback current at the q-axis is sampled, and the q-axis inductance is calculated according to the equation: $i_q = \dfrac{u_q}{r_s}(1 - e^{-\frac{r_s}{L_q}t})$ .

The method above has the following disadvantages.

1. The position of the d-axis (rotor magnetic pole axis) of the motor is obtained by applying a direct current (DC), and in the case where the shaft of the motor cannot rotate, e.g., in a machine with a brake such as an elevator traction machine, the position of the d-axis of the motor cannot be obtained.

2. The stator resistance $r_s$ of the motor needs to be determined first, and the accuracy of the stator resistance $r_s$ will affect the accuracy of the inductance parameter identified.

3. The amplitude of the fixed voltage applied is difficult to determine. A large amplitude of the fixed voltage applied may cause overcurrent, while a small amplitude of the fixed voltage applied may result in a small current and thus affect the accuracy of detection. Moreover, the period of time for applying the q-axis voltage has to be short; otherwise the motor may rotate, thus resulting in inaccuracy in the identification of the inductance parameter of the q-axis.

4. The requirements on current sampling are relatively high because of the short period of time for applying the fixed voltage. Current sampling has to be fast and accurate; otherwise deviation in parameter identification may be caused.

**SUMMARY OF THE INVENTION**

In view of the disadvantages discussed above of the prior art including detection and calculation difficulties of the direct-axis inductance $L_d$ and quadrature-axis inductance Lq of a synchronous motor, according to the present invention, it is provided an inductance parameter identification method for a synchronous motor and an implementation system thereof, in which a balanced three-phase high-frequency voltage or current signal is applied to the synchronous motor, a feedback high-frequency current or voltage from the synchronous motor is sampled, and the d-axis inductance $L_d$ and q-axis inductance Lq of the synchronous motor are calculated according to the amplitude of a positive sequence component and the amplitude of a negative sequence component of the feedback high-frequency current or voltage.

The technical solution provided by the present invention to solve the technical problem comprises an inductance parameter identification method for a synchronous motor. The method comprises: injecting a plurality of high-frequency voltage or current signals having three-phase balanced to a stationary alpha-beta ($\alpha$-$\beta$) axes coordinate system of the synchronous motor chosen at random; obtaining an amplitude of a positive sequence component and an amplitude of a negative sequence component of a feedback high-frequency current or voltage signal from the synchronous motor having the same frequency as the injected the plurality of high-frequency voltage or current signals; and calculating an inductance $L_d$ of a d-axis and an inductance Lq of a q-axis at a direct-quadrature (d-q) axes coordinate system of the synchronous motor according to the amplitude of the positive sequence component and the amplitude of the negative sequence component of the feedback high-frequency current or voltage signal.

According to the present invention, it is also provided a system for implementing the inductance parameter identification method for the synchronous motor above. The system comprises a high-frequency voltage/current injection module, a filter module, a high-frequency current/voltage positive and negative sequence components extraction module and an inductance calculation module, wherein

the high-frequency voltage/current injection module is adapted to inject a high-frequency voltage or current to a stationary alpha-beta ($\alpha$-$\beta$) axes coordinate system of the synchronous motor;

the filter module is adapted to extract a high-frequency current or voltage having the same frequency as the injected voltage or current from a feedback high-frequency current or voltage;

the high-frequency current/voltage positive and negative sequence components extraction module is adapted to perform a positive sequence and a negative sequence high-frequency rotation transformation respectively on the high-frequency current or voltage from the filter module, and extract a negative sequence component and a positive sequence component by a high-pass filter; and

the inductance calculation module is adapted to calculate an inductance $L_d$ of a d-axis and an inductance Lq of a q-axis at a direct-quadrature (d-q) axes coordinate system of the synchronous motor according to the positive sequence component and the negative sequence component of the high-frequency current or voltage.

The technical solution provided by the present invention to solve the technical problem may further comprise:

at the step of injection the amplitude of the plurality of high-frequency voltage or current signals injected to the synchronous motor increases gradually from zero.

Before the step of calculating the inductance $L_d$ of the d-axis and the inductance Lq of the q-axis at the d-q axes coordinate system of the synchronous motor according to the amplitude of the positive sequence component and the amplitude of the negative sequence component of the feedback high-frequency current or voltage signal, the inductance parameter identification method may further comprise: determining whether the amplitude of the positive sequence component of the feedback high-frequency current or voltage signal reaches a predetermined value, or determining whether the amplitude of the plurality of high-frequency voltage or current signals injected to the synchronous motor reaches a predetermined value; and calculating the inductance $L_d$ of the d-axis and the inductance Lq of the q-axis at the d-q axes coordinate system of the synchronous motor if the amplitude of the positive sequence component of the feedback high-frequency current or voltage signal reaches a predetermined value, or if the amplitude of the plurality of high-frequency voltage or current signals injected to the synchronous motor reaches a predetermined value.

The step of obtaining may comprise:

obtaining the feedback high-frequency current or voltage signal from the synchronous motor; and

extracting the amplitude of the positive sequence component and the amplitude of the negative sequence component of the feedback high-frequency current or voltage signals from the synchronous motor having the same frequency as the injected the plurality of high-frequency voltage or current signals.

The step of extracting may comprise:

filtering the feedback high-frequency current or voltage signals from the synchronous motor sampled with a band-pass filter so as to extract a high-frequency component having the same frequency as the injected the plurality of high-frequency current or voltage signals;

performing the positive sequence and the negative sequence high-frequency rotation transformation respectively on the high-frequency component of the high-frequency current or voltage signals; and

removing a direct current component of the high-frequency component of the high-frequency current or voltage signals after being transformed by a high-pass filter so as to obtain the amplitude of the negative sequence component and the amplitude of the positive sequence component.

In the case where the d-axis inductance $L_d$ and the q-axis inductance Lq of the synchronous motor are calculated according to the amplitude of the positive sequence component and the amplitude of the negative sequence component of sampled feedback high-frequency current, the calculation is based on the equation:

$$L_d = \frac{V_i}{\omega_i(I_p + I_n)}$$
$$L_q = \frac{V_i}{\omega_i(I_p - I_n)}$$

, where $V_i$ denotes the amplitude of the injected high-frequency voltage, $\omega_i$ denotes the angular frequency of the injected high-frequency voltage, $I_p$ denotes the amplitude of the positive sequence component of the feedback high-frequency current, and $I_n$ denotes the amplitude of the negative sequence component of the feedback high-frequency current; and in the case where the d-axis inductance $L_d$ and the q-axis inductance Lq of the synchronous motor are calculated according to the amplitude of the positive sequence component and the amplitude of the negative sequence component of sampled feedback high-frequency voltage, the calculation is based on the equation:

$$L_d = \frac{(V_p - V_n)}{\omega_i I_i}$$
$$L_q = \frac{(V_p + V_n)}{\omega_i I_i}$$

, where $I_i$ denotes the amplitude of the injected high-frequency current, $\omega_i$ denotes the angular frequency of the injected high-frequency current, $V_p$ denotes the amplitude of the positive sequence component of the feedback high-frequency voltage, and $V_n$ denotes the amplitude of the negative sequence component of the feedback high-frequency voltage.

The step of injecting may comprise: injecting the plurality of high-frequency voltage or current signals having three-phase balanced to the synchronous motor by a Pulse-width modulation (PWM) module of an inverter, wherein the frequency of the high-frequency voltage or current signal injected to the synchronous motor is higher than a rated frequency of the synchronous motor, and lower than a PWM carrier frequency of the inverter.

The predetermined value ranges from 20% to 100% of a rated current value or a rated voltage value of the synchronous motor.

The predetermined value ranges from 20% to 100% of a rated voltage value or a rated current value of the synchronous motor.

The system may further comprise an inverter Space Vector PWM (SVPWM) module, and the high-frequency voltage or current injected by the high-frequency voltage/current injection module is injected to the synchronous motor by the inverter SVPWM module.

The system may further comprise a high-frequency current/voltage positive and negative sequence component amplitude calculation module, which is adapted to calculate the amplitude of the positive sequence component and the amplitude of the negative sequence component of the feedback high-frequency current or voltage; and the inductance calculation module is adapted to calculate the inductance $L_d$ of the d-axis and the inductance Lq of the q-axis of the synchronous motor according to the amplitude of the positive sequence component and the amplitude of the negative sequence component of the feedback high-frequency current or voltage.

The filter module may comprise a band-pass filter, and the band-pass filter is adapted to remove a direct current component and PWM carrier noise from the feedback high-frequency current or voltage, wherein a band-pass frequency of the band-pass filter has the same frequency as the injected high-frequency voltage or current.

The method may comprise the steps of:

A. arbitrarily choosing a stationary alpha-beta ($\alpha$-$\beta$) reference frame, and injecting a high-frequency voltage or current signal to the synchronous motor, wherein the amplitude of the voltage or current increases gradually from zero;

B. obtaining a feedback current or voltage from the synchronous motor, and obtaining a transient value of the feedback high-frequency current or voltage having the same frequency as the injected voltage or current by a band-pass filter;

C. performing positive sequence transformation on the obtained transient value of the high-frequency current or voltage so that a positive sequence component of the high-frequency current or voltage is transformed into a direct current component, and a negative sequence component of the high-frequency current or voltage is transformed into a sine function of a frequency; removing the direct current component by a high-pass filter so as to obtain the negative sequence component of the feedback current or voltage; and calculating the amplitude of the negative sequence component;

D. performing negative sequence transformation on the high-frequency current or voltage obtained in step B so that the negative sequence component of the high-frequency current or voltage is transformed into a direct current component, and the positive sequence component of the high-frequency current or voltage is transformed into a sine function of the frequency $2\omega_i$; removing the direct current component by a high-pass filter so as to obtain the positive sequence component of the feedback current or voltage; and calculating the amplitude of the positive sequence component according to the positive sequence component of the feedback current or voltage;

E. repeating the steps A to D until the amplitude of the positive sequence component of the feedback high-frequency current or voltage reaches a predetermined value or the amplitude of the injected high-frequency voltage or current reaches a predetermined value where the amplitude of the injected high-frequency voltage or current is maintained unchanged; and then repeating the steps C and D; and calculating the d-axis inductance $L_d$ and the q-axis inductance Lq of the synchronous motor; and

F. stopping the injection of the high-frequency voltage or current, and ending the parameter identification process.

The frequency of the high-frequency voltage or current may range from 0.1 KHz to 1 KHz.

The present invention may bring the following advantages. The present invention can achieve accurate identification of the d-axis inductance and q-axis inductance of a synchronous motor using a general-purpose frequency-variable device without hardware cost increase. The present invention is easy to implement. It imposes no high requirements on the accuracy of the sampling of the feedback current from the motor. The frequency and amplitude of the high-frequency voltage signal injected to the motor are easy to control. Moreover, the d-axis inductance and q-axis inductance of the motor can be directly identified, whether the shaft of the motor is free or braked, without affecting the accuracy of identification. By the present invention, accurate identification of the d-axis inductance and q-axis inductance of surface-mount synchronous motors, embedded synchronous motors and elctroexcitation synchronous motors can be achieved. In addition, the parameter obtained from identification can be used in vector control algorithms of the synchronous motor.

The present invention will be described hereinafter in detail in conjunction with the accompanying drawings and the embodiments.

**BRIEF DESCRIPTION OF THE DRAWINGS**

Figure 1 is a structural diagram illustrating identification of the d-axis inductance and q-axis inductance of a synchronous motor using a high-frequency voltage injection method according to the present invention; and

Figure 2 is a flow chart of identification of the d-axis inductance and q-axis inductance of a synchronous motor using a high-frequency voltage injection method according to the present invention.

**DETAILED DESCRIPTION OF THE EMBODIMENTS**

Preferred embodiments of the present invention are described below, and other embodiments with the same or similar principle or basic structure shall all fall within the scope of protection of the present invention.

An embodiment of the present invention comprises: injecting a plurality of high-frequency voltage or current signals having three-phase balanced to a stationary alpha-beta ($\alpha$-$\beta$) axes coordinate system of the synchronous motor chosen at random; obtaining an amplitude of a positive sequence component and an amplitude of a negative sequence component of a feedback high-frequency current or voltage signal from the synchronous motor having the same frequency as the injected the plurality of high-frequency voltage or current signals; and calculating an inductance $L_d$ of a d-axis and an inductance Lq of a q-axis at a direct-quadrature (d-q) axes coordinate system of the synchronous motor according to the amplitude of the positive sequence component and the amplitude of the negative sequence component of the feedback high-frequency current or voltage signal. In the embodiment of the present invention, in the injection of a plurality of high-frequency voltage or current signals having three-phase balanced to the synchronous motor, the amplitude of the voltage or current injected to the synchronous motor may increase gradually from zero; meanwhile, it is judged whether the amplitude of the positive sequence component of the feedback high-frequency current or voltage reaches a predetermined value or whether the amplitude of the injected high-frequency voltage or current reaches a predetermined value, and the d-axis inductance $L_d$ and the q-axis inductance Lq of the synchronous motor are calculated if the result of judgment is yes.

The basic synchronous motor theory relating to the embodiment of the present invention comprises:

In the case where the power supply of the speed control system is powered by an SVPWM voltage-source inverter, a balanced three-phase high-frequency voltage signal may be applied directly to the synchronous motor by the inverter. Assuming the angular frequency of the injected high-frequency voltage is $\omega_i$, the amplitude of the injected high-frequency voltage is $V_i$, and a $\alpha$-$\beta$ reference frame is used, then the injected high-frequency voltage signal may be expressed as:

$$u_{s\alpha} = V_i \cos(\omega_i t)$$
$$u_{s\beta} = V_i \sin(\omega_i t)$$

Equation (1)

The frequency of the injected high-frequency voltage signal may be 0.1 KHz to 1 KHz, i.e., higher than the rated frequency of the motor and lower than the PWM carrier frequency of the inverter. Excited by such a high-frequency signal, the voltage drop across the stator of the synchronous motor can be omitted and the synchronous motor does not rotate; thus there is no counter-electromotive force, and the voltage model of the synchronous motor may be simplified as:

$$u^s{}_{s\alpha\beta} \approx L^s{}_{\alpha\beta} \frac{di^{\cdot s}{}_{s\alpha\beta}}{dt}$$

Equation (2)

The variables with a superscript S in Equation (2) above are matrices, specifically,

$$L^s{}_{\alpha\beta} = \begin{bmatrix} L + \Delta L \cos(2\theta_r) & -\Delta L \sin(2\theta_r) \\ -\Delta L \sin(2\theta_r) & L - \Delta L \cos(2\theta_r) \end{bmatrix}$$

Equation (3)

In Equation (3) above, $L=(L_d+L_q)/2$, $\Delta L=(L_q-L_d)/2$, and $\theta_r$ is the spatial electrical angle between the stator $\alpha$-axis and the rotor magnetic pole axis (d-axis).

According to Equations (2) and (3), excited by the high-frequency voltage signal, the amplitude of the high-frequency positive sequence component and the amplitude of the high-frequency negative sequence component of a feedback high-frequency current of the synchronous motor are:

$$I_p = \left[ \frac{L_d + L_q}{2 L_d L_q} \right] \frac{V_i}{\omega_i}$$

$$I_n = \left[ \frac{L_q - L_d}{2 L_d L_q} \right] \frac{V_i}{\omega_i}$$

Equation (4)

According to Equation (4) above, the d-axis inductance $L_d$ and the q-axis inductance Lq of the motor can be obtained from the amplitude of the positive sequence component, $I_p$, and the amplitude of the negative sequence component, $I_n$, of the feedback high-frequency current:

$$L_d = \frac{V_i}{\omega_i(I_p + I_n)}$$

$$L_q = \frac{V_i}{\omega_i(I_p - I_n)} \qquad \text{Equation (5)}$$

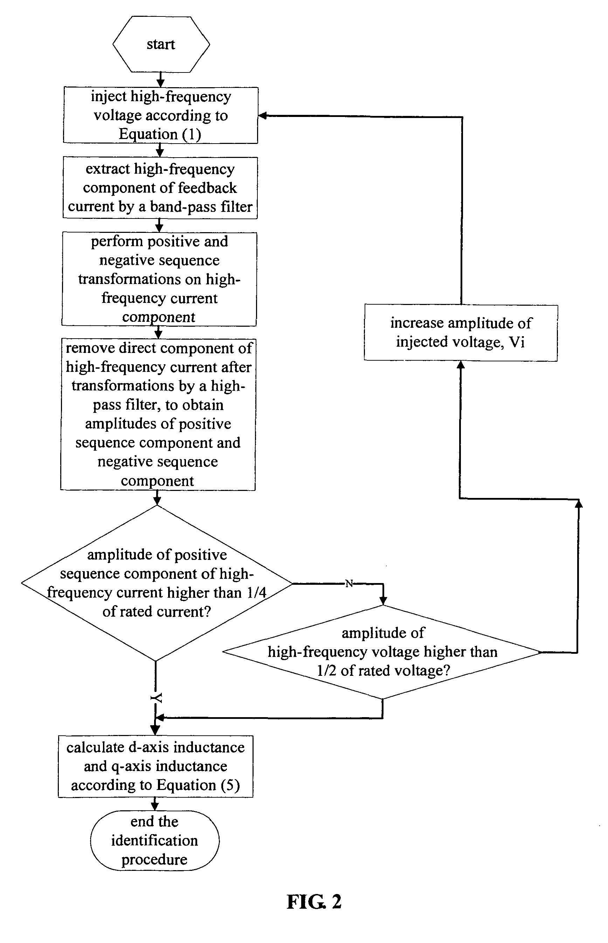

As shown in Figure 2, a high-frequency voltage injection method for identifying the d-axis inductance and q-axis inductance of a synchronous motor according to an embodiment of the present invention may comprise the following steps.

1. A stationary $\alpha$-$\beta$ reference frame is arbitrarily chosen, and a high-frequency excitation voltage signal is injected to the synchronous motor according to Equation (1), i.e., $u_{sa} = V_i \cos(\omega_i t)$ $u_{s\beta} = V_i sin(\omega_i t)$, with the amplitude of the voltage, $V_i$, increasing gradually from zero. Generally, the process of increasing may take hundreds of milliseconds to seconds. If the speed of the increasing of the voltage amplitude is too fast, overflow may be caused, which can damage the motor. The process of the increasing of the voltage amplitude may be set according to actual needs without damaging the motor.

2. A feedback high-frequency current from the synchronous motor is sampled by a sampling circuit, and a high-frequency component that has the same frequency as the injected voltage of the feedback current is extracted by a band-pass filter, i.e., a transient value of the feedback high-frequency current (which, in the embodiment, has the same frequency as the injected voltage), $i^s s \alpha\beta$. In the embodiment, the center frequency of the band-pass filter may be the frequency of the injected high-frequency voltage signal, $\omega_i$.

3. Positive sequence transformation is performed on the obtained transient value of the high-frequency current, $i^s s \alpha\beta$, so that a positive sequence component of the high-frequency current $i^s s \alpha\beta$ is transformed into a direct current component, and a negative sequence component of $i^s s \alpha\beta$ is transformed into a sine function of the frequency $2\omega_i$; then the direct current component (which represents the positive sequence component) is removed by a high-pass filter so as to obtain the negative sequence component of the feedback current, $i_n^s s \alpha\beta$ (i.e., $i_{ns\alpha}$, $i_{ns\beta}$); and the

amplitude of the negative sequence component, $I_n = \sqrt{i_{ns\alpha}^2 + i_{ns\beta}^2}$ , can be calculated.

4. Negative sequence transformation (with a rotation frequency - $\omega_i$) is performed on the high-frequency current obtained in step 2, $i^s s \alpha\beta$, so that the negative sequence component of the high-frequency current $i^s s\alpha\beta$ is transformed into a direct current component, and the positive sequence component of $i^s s\alpha\beta$ is transformed into a sine function of the frequency $2\omega_i$; then the direct current component (which represents the negative sequence component) is removed by a high-pass filter so as to obtain the positive sequence component of the feedback current, $i_p^s s\alpha\beta$ (i.e., $i_{ps\alpha}$, $i_{ps\beta}$); and the amplitude of the positive sequence component, $I_p$, can be calculated.

5. The steps 1 to 4 are repeated until the amplitude of the positive sequence component of the feedback high-frequency current, $I_p$, reaches a predetermined value (which in the embodiment may be 20% to 100% of the rated current of the motor, e.g., 1/4 of the rated current ) or the amplitude of the injected high-frequency voltage, $V_i$, reaches a predetermined value (which in the embodiment may be 20% to 100% of the rated voltage of the motor, e.g., 1/2 of the rated voltage) where the amplitude of the injected high-frequency voltage, $V_i$, is maintained unchanged; and then the steps 3 and 4 are repeated; and the d-axis inductance $L_d$ and the q-axis inductance Lq of the synchronous motor is calculated according to Equation (5), i.e.,

$$L_d = \frac{V_i}{\omega_i(I_p + I_n)}$$

$$L_q = \frac{V_i}{\omega_i(I_p - I_n)} .$$

To ensure a certain accuracy of identification, the amplitude of the positive sequence component of the feedback

high-frequency current, I_p, needs to be larger than a particular value. Generally, the amplitude of the positive sequence component of the feedback high-frequency current, I_p, may need to be larger than 20% of the rated current of the rotor, in which case I_p may be 20% to 100% of the rated current of the motor, e.g., 1/4 of the rated current.
6. The injection of the high-frequency voltage is stopped, and the parameter identification process ends.

The embodiment above is a high-frequency voltage injection method for identifying the d-axis inductance and q-axis inductance of a synchronous motor, in which a balanced three-phase high-frequency voltage is injected to the synchronous motor, a feedback high-frequency current from the synchronous motor is sampled, and the d-axis inductance $L_d$ and q-axis inductance Lq of the synchronous motor are calculated according to the amplitude of a positive sequence component and the amplitude of a negative sequence component of the feedback high-frequency current. The present invention may also be implemented in another way, i.e., a high-frequency current injection method for identifying the d-axis inductance and q-axis inductance of a synchronous motor. It differs from the high-frequency voltage injection method in that, the high-frequency current injection method injects a high-frequency current to the synchronous motor and obtains a feedback high-frequency voltage (generally, the command voltage output by the inverter module is the output voltage of the motor, which can be obtained without sampling, whereas the current output by the motor needs to be sampled to obtain). The process for obtaining the d-axis inductance $L_d$ and q-axis inductance Lq of the synchronous motor using the amplitude of the positive sequence component and the amplitude of the negative sequence component of a feedback high-frequency voltage is similar to the high-frequency voltage injection method, which is therefore omitted here. However, it is noted that the high-frequency current injecting method may comprise performing PI control on the commanded high-frequency current and the feedback high-frequency current, and inputting a high-frequency voltage from PI adjustment to the motor by a PWM module of the inverter; and the obtained high-frequency voltage generally is the commanded high-frequency voltage.

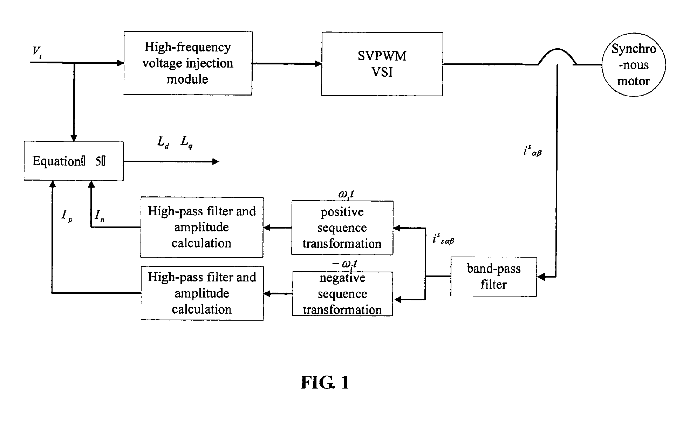

The present invention also provides a system for implementing the inductance parameter identification method for a synchronous motor above. As shown in Figure 1, according to an embodiment of the present invention, a system for implementing the inductance parameter identification method for a synchronous motor comprises: a high-frequency voltage injection module, a inverter SVPWM module, a filter module, a high-frequency current positive and negative sequence components extraction module, a high-frequency current positive and negative sequence component amplitude calculation module, and an inductance calculation module.

The high-frequency voltage injection module is adapted to inject a high-frequency voltage signal to a stationary reference frame, $\alpha$-$\beta$ coordinates, of the synchronous motor according to the high-frequency voltage signal

$$u_{s\alpha} = V_i \cos(\omega_i t)$$
$$u_{s\beta} = V_i \sin(\omega_i t)$$
where the frequency of the injected high-frequency voltage is $\omega_i$, and the amplitude of the injected high-frequency voltage is $V_i$.

The inverter SVPWM module is adapted to input the injected high-frequency voltage to the synchronous motor. In practice, the high-frequency voltage may be input to the synchronous motor in other manners.

The filter module is adapted to extract a high-frequency feedback current that has the same frequency as the injected voltage from the feedback current. In the embodiment, the filter module may comprise a band-pass filter, which removes a direct current component and PWM carrier noise from the feedback current. In the embodiment, the band-pass filter may have a passband consistent with the frequency of the injected voltage. In practice, the high-frequency feedback current that has the same frequency as the injected voltage may be extracted from the feedback current in other manners.

The high-frequency current positive and negative sequence components extraction module is adapted to perform positive sequence ( $\omega_i t$ ) and negative sequence ( $-\omega_i t$ ) transformations on the high-frequency current from the filter module, and extract a negative sequence component $(i_{ns\alpha 1}, i_{ns\beta 1})$ and a positive sequence component $(i_{ps\alpha 1}, i_{ps\beta 1})$ by a high-pass filter.

The high-frequency current positive and negative sequence component amplitude calculation module is adapted to calculate the amplitude of the positive sequence component, $I_p = \sqrt{I_{ps\alpha 1}^2 + I_{ps\beta 1}^2}$, and the amplitude of the negative sequence component amplitude, $I_n = \sqrt{I_{ns\alpha 1}^2 + I_{ns\beta 1}^2}$, because the coordinate transformations do not affect the amplitudes of the positive and negative sequence components.

The inductance calculation module is adapted to calculate the d-axis inductance $L_d$ and the q-axis inductance Lq of the motor according to the equation:

$$L_d = \frac{V_i}{\omega_i(I_p + I_n)}$$

$$L_q = \frac{V_i}{\omega_i(I_p - I_n)}$$

In the embodiment above, it is a high-frequency voltage signal that is injected to the synchronous motor, which is thus a high-frequency voltage injection method. The present invention may also be implemented in anther way, i.e., by injecting a high-frequency current signal to the synchronous motor, which is thus a high-frequency current injection method.

The principle of the high-frequency current injection method is in accordance with that of the high-frequency voltage injection method, both of which make use of the magnetic saliency of a synchronous motor. In the case where a high-frequency voltage signal is injected, the high-frequency current of the synchronous motor has a difference-frequency characteristic, so a positive sequence component and a negative sequence component of the corresponding current signal are extracted, to obtain the inductance parameter; and in the case where a high-frequency current signal is injected, the high-frequency voltage of the synchronous motor has a difference-frequency characteristic, so a positive sequence component and a negative sequence component of the corresponding voltage signal are extracted, to obtain the inductance parameter.

The derivations of the high-frequency current injection method are similar to those of the high-frequency voltage injection method, which are therefore omitted here. The d-axis inductance $L_d$ and the q-axis inductance Lq of the motor may be calculated according to the equation:

$$L_d = \frac{(V_p - V_n)}{\omega_i I_i}$$
$$L_q = \frac{(V_p + V_n)}{\omega_i I_i}$$

Equation (6)

In Equation (6) above, $I_i$ is the amplitude of the injected high-frequency current, $V_p$ is the amplitude of the positive sequence component of the high-frequency voltage, and $V_n$ is the amplitude of the negative sequence component of the high-frequency voltage.

For a synchronous motor with no magnetic saliency such as surface-mount synchronous motor, the negative sequence component of the high-frequency current (voltage) is approximately zero, and $L_d \approx L_q$ can be obtained according to the Equations (5) and (6).

The present invention can achieve accurate identification of the d-axis inductance and q-axis inductance of a synchronous motor using a general-purpose frequency-variable device without hardware cost increase. The present invention is easy to implement. It imposes no high requirements on the accuracy of the sampling of the feedback current from the motor. The frequency and amplitude of the high-frequency voltage signal injected to the motor are easy to control. Moreover, the d-axis inductance and q-axis inductance of the motor can be directly identified, whether the shaft of the motor is free or braked, without affecting the accuracy of identification. By the present invention, accurate identification of the d-axis inductance and q-axis inductance of surface-mount synchronous motors, embedded synchronous motors and elctroexcitation synchronous motors can be achieved. In addition, the parameter obtained from identification can be used in vector control algorithms of the synchronous motor.

**Claims**

1. An inductance parameter identification method for a synchronous motor, comprising:

    injecting a plurality of high-frequency voltage or current signals having three-phase balanced to a stationary alpha-beta ($\alpha$-$\beta$) axes coordinate system of the synchronous motor chosen at random;
    obtaining an amplitude of a positive sequence component and an amplitude of a negative sequence component of a feedback high-frequency current or voltage signal from the synchronous motor having the same frequency as the injected the plurality of high-frequency voltage or current signals; and

calculating an inductance $L_d$ of a d-axis and an inductance Lq of a q-axis at a direct-quadrature (d-q) axes coordinate system of the synchronous motor according to the amplitude of the positive sequence component and the amplitude of the negative sequence component of the feedback high-frequency current or voltage signal.

2. The inductance parameter identification method for the synchronous motor as claimed in claim 1, wherein the amplitude of the plurality of high-frequency voltage or current signals injected to the synchronous motor increases gradually from zero at the step of injection.

3. The inductance parameter identification method for the synchronous motor as claimed in claim 2, wherein before the step of calculating the inductance $L_d$ of the d-axis and the inductance Lq of the q-axis at the d-q axes coordinate system of the synchronous motor according to the amplitude of the positive sequence component and the amplitude of the negative sequence component of the feedback high-frequency current or voltage signal, the inductance parameter identification method further comprises:

determining whether the amplitude of the positive sequence component of the feedback high-frequency current or voltage signal reaches a predetermined value, or determining whether the amplitude of the plurality of high-frequency voltage or current signals injected to the synchronous motor reaches a predetermined value; and calculating the inductance $L_d$ of the d-axis and the inductance Lq of the q-axis at the d-q axes coordinate system of the synchronous motor if the amplitude of the positive sequence component of the feedback high-frequency current or voltage signal reaches a predetermined value, or if the amplitude of the plurality of high-frequency voltage or current signals injected to the synchronous motor reaches a predetermined value.

4. The inductance parameter identification method for the synchronous motor as claimed in claim 1, wherein the step of obtaining comprises:

obtaining the feedback high-frequency current or voltage signal from the synchronous motor; and extracting the amplitude of the positive sequence component and the amplitude of the negative sequence component of the feedback high-frequency current or voltage signals from the synchronous motor having the same frequency as the injected the plurality of high-frequency voltage or current signals.

5. The inductance parameter identification method for the synchronous motor as claimed in claim 4, wherein the step of extracting comprises:

filtering the feedback high-frequency current or voltage signals from the synchronous motor sampled with a band-pass filter so as to extract a high-frequency component having the same frequency as the injected the plurality of high-frequency current or voltage signals; performing the positive sequence and the negative sequence high-frequency rotation transformation respectively on the high-frequency component of the high-frequency current or voltage signals; and removing a direct current component of the high-frequency component of the high-frequency current or voltage signals after being transformed by a high-pass filter so as to obtain the amplitude of the negative sequence component and the amplitude of the positive sequence component.

6.

The inductance parameter identification method for the synchronous motor as claimed in any one of claims 1-5, wherein in the case where the d-axis inductance $L_d$ and the q-axis inductance Lq of the synchronous motor are calculated according to the amplitude of the positive sequence component and the amplitude of the negative sequence component of sampled feedback high-frequency current, the calculation is based on the equation:

$$L_d = \frac{V_i}{\omega_i(I_p + I_n)}$$

, where $V_i$ denotes the amplitude of the injected high-frequency voltage, $\omega_i$ denotes the angular

$$L_q = \frac{V_i}{\omega_i(I_p - I_n)}$$

frequency of the injected high-frequency voltage, $I_p$ denotes the amplitude of the positive sequence component of the feedback high-frequency current, and $I_n$ denotes the amplitude of the negative sequence component of the feedback high-frequency current; and in the case where the d-axis inductance $L_d$ and the q-axis inductance Lq of the synchronous motor are calculated according to the amplitude of the positive sequence component and the amplitude of the negative sequence component of sampled feedback high-frequency voltage, the calculation is based on the equation:

$$L_d = \frac{(V_p - V_n)}{\omega_i I_i}$$
$$L_q = \frac{(V_p + V_n)}{\omega_i I_i},$$

where $I_i$ denotes the amplitude of the injected high-frequency current, $\omega_i$ denotes the angular frequency of the injected high-frequency current, $V_p$ denotes the amplitude of the positive sequence component of the feedback high-frequency voltage, and $V_n$ denotes the amplitude of the negative sequence component of the feedback high-frequency voltage.

7. The inductance parameter identification method for the synchronous motor as claimed in any one of claims 1-5, wherein the step of injecting comprises:

injecting the plurality of high-frequency voltage or current signals having three-phase balanced to the synchronous motor by a Pulse-width modulation (PWM) module of an inverter, wherein the frequency of the high-frequency voltage or current signal injected to the synchronous motor is higher than a rated frequency of the synchronous motor, and lower than a PWM carrier frequency of the inverter.

8. The inductance parameter identification method for the synchronous motor as claimed in claim 2, wherein the predetermined value for the amplitude of the positive sequence component of the feedback high-frequency current or voltage ranges from 20% to 100% of a rated current value or a rated voltage value of the synchronous motor.

9. The inductance parameter identification method for the synchronous motor as claimed in claim 2, wherein the predetermined value for the amplitude of the injected high-frequency voltage or current ranges from 20% to 100% of a rated voltage value or a rated current value of the synchronous motor.

10. A system for implementing the inductance parameter identification method for the synchronous motor as claimed in claim 1, comprising a high-frequency voltage/current injection module, a filter module, a high-frequency current/voltage positive and negative sequence components extraction module and an inductance calculation module, wherein
the high-frequency voltage/current injection module is adapted to inject a high-frequency voltage or current to a stationary alpha-beta ($\alpha$-$\beta$) axes coordinate system of the synchronous motor;
the filter module is adapted to extract a high-frequency current or voltage having the same frequency as the injected voltage or current from a feedback high-frequency current or voltage;
the high-frequency current/voltage positive and negative sequence components extraction module is adapted to perform a positive sequence and a negative sequence high-frequency rotation transformation respectively on the high-frequency current or voltage from the filter module, and extract a negative sequence component and a positive sequence component by a high-pass filter; and
the inductance calculation module is adapted to calculate an inductance $L_d$ of a d-axis and an inductance Lq of a q-axis at a direct-quadrature (d-q) axes coordinate system of the synchronous motor according to the positive sequence component and the negative sequence component of the high-frequency current or voltage.

11. The system as claimed in claim 10, wherein the system further comprises an inverter Space Vector PWM (SVPWM) module, and the high-frequency voltage or current injected by the high-frequency voltage/current injection module is injected to the synchronous motor by the inverter SVPWM module.

12. The system as claimed in claim 10, wherein the system further comprises a high-frequency current/voltage positive and negative sequence component amplitude calculation module adapted to calculate the amplitude of the positive sequence component and the amplitude of the negative sequence component of the feedback high-frequency current or voltage; and
the inductance calculation module is adapted to calculate the inductance $L_d$ of the d-axis and the inductance Lq of the q-axis of the synchronous motor according to the amplitude of the positive sequence component and the amplitude of the negative sequence component of the feedback high-frequency current or voltage.

13. The system as claimed in claim 10, wherein the filter module comprise a band-pass filter, and the band-pass filter is adapted to remove a direct current component and PWM carrier noise from the feedback high-frequency current or voltage, wherein a band-pass frequency of the band-pass filter is the same as frequency of the injected high-frequency voltage or current.

$V_i$ ──▶ High-frequency voltage injection module ──▶ SVPWM VSI ──▶ Synchro -nous motor

Equation 5 ── $L_d$ $L_q$ ──▶

$i^s{}_{\alpha\beta}$

$I_p$ $I_n$ High-pass filter and amplitude calculation ◀── $\omega_i t$ positive sequence transformation ◀── $i^s{}_{s\alpha\beta}$

High-pass filter and amplitude calculation ◀── $-\omega_i t$ negative sequence transformation ◀── band-pass filter ◀──

**FIG. 1**

**FIG. 2**

## INTERNATIONAL SEARCH REPORT

| International application No. |
|---|
| PCT/CN2011/072314 |

### A. CLASSIFICATION OF SUBJECT MATTER

See extra sheet

According to International Patent Classification (IPC) or to both national classification and IPC

### B. FIELDS SEARCHED

Minimum documentation searched (classification system followed by classification symbols)

IPC: G01R; H02P

Documentation searched other than minimum documentation to the extent that such documents are included in the fields searched

Electronic data base consulted during the international search (name of data base and, where practicable, search terms used)

WPI,EPODOC,CNKI,CNPAT,PMSM,permanent w magnet,synchronous w motor,parameter,estimation,inductance

### C. DOCUMENTS CONSIDERED TO BE RELEVANT

| Category* | Citation of document, with indication, where appropriate, of the relevant passages | Relevant to claim No. |
|---|---|---|
| A | CN101650390A (SUZHOU ECONOMY TRADING CAREER TECHNOLOGY COLLEGE) 17 Feb. 2010 (17.02.2010) the whole document | 1-13 |
| A | CN101261294A (CHERY AUTOMOBILE CO., LTD.) 10 Sep. 2008 (10.09.2008) the whole document | 1-13 |
| A | US2010/0060210A1 (HARBAUGH M M et al.) 11 Mar. 2010 (11.03.2010) the whole document | 1-13 |

☒ Further documents are listed in the continuation of Box C.   ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim (S) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&"document member of the same patent family |

| Date of the actual completion of the international search | Date of mailing of the international search report |
|---|---|
| 11 Dec. 2011 (11.12.2011) | **05 Jan. 2012 (05.01.2012)** |

| Name and mailing address of the ISA/CN<br>The State Intellectual Property Office, the P.R.China<br>6 Xitucheng Rd., Jimen Bridge, Haidian District, Beijing, China<br>100088<br>Facsimile No. 86-10-62019451 | Authorized officer<br><br>LI,Hang<br><br>Telephone No. (86-10)4178 |
|---|---|

Form PCT/ISA /210 (second sheet) (July 2009)

**INTERNATIONAL SEARCH REPORT**

| International application No. |
| --- |
| PCT/CN2011/072314 |

C (Continuation).     DOCUMENTS CONSIDERED TO BE RELEVANT

| Category* | Citation of document, with indication, where appropriate, of the relevant passages | Relevant to claim No. |
| --- | --- | --- |
| A | LIU Jun et al.,The Parameter Measurement of Permanent Magnet Synchronous Motor 《Power Electronics》, Vol. 44, No. 1, pages 46-48, January, 2010 | 1-13 |
| A | CHEN Zhenfeng et al., An Off-line Parameter Estimation Technique for Permanent Magnet Synchronous Motor,  《Power Electronics》,Vol. 43, No. 11, pages 43-44, November, 2009 | 1-13 |

Form PCT/ISA /210 (continuation of second sheet ) (July 2009)

**INTERNATIONAL SEARCH REPORT**
Information on patent family members

| International application No. |
| --- |
| PCT/CN2011/072314 |

| Patent Documents referred in the Report | Publication Date | Patent Family | Publication Date |
| --- | --- | --- | --- |
| CN101650390A | 17.02.2010 | NONE | |
| CN101261294A | 10.09.2008 | WO2009129684A1 | 29.10.2009 |
| US2010/0060210A1 | 11.03.2010 | NONE | |

Form PCT/ISA /210 (patent family annex) (July 2009)

# INTERNATIONAL SEARCH REPORT

International application No.

PCT/CN2011/072314

**Continuation of : A.    CLASSIFICATION OF SUBJECT MATTER**

G01R27/26  (2006.01) i
H02P21/14  (2006.01) i

Form PCT/ISA /210 (extra sheet) (July 2009)